# EUROPEAN PATENT APPLICATION

(11) **EP 4 093 010 A1**
(43) Date of publication of application: **23.11.2022**
(21) Application number: 21175098.9
(22) Date of filing: 20.05.2021
(51) Int. Cl.: H04N 5/225, G02F 1/15

(54) **INFRARED ILLUMINATOR**

(71) Applicant: Aptiv Technologies Limited, St. Michael (BB)
(72) Inventor: REWILAK, Krzysztof, Dublin, 2 (IE); BARSZCZOWSKI, Maciej, Dublin, 2 (IE)
(74) Representative: Gaunt, Thomas Derrick

(57) **Abstract**

Infrared illuminator (1) including an IR emitter (2) and an IR window (3) for transmitting IR radiation from the IR emitter (2) to a field of illumination (4). The IR window (3) includes a electrochromic material for varying the transmittance of IR radiation through the IR window in response to an applied electric field.

## Description

### Introduction

The present disclosure relates to infrared (IR) illuminators and IR source devices. The present disclosure is particularly relevant to automotive IR assemblies for use with automotive cameras such as driver monitoring cameras.

### Background

Infrared based sensor systems have become common in automotive applications. For example, IR cameras are often used within the interior of vehicles for monitoring the driver's awareness. Typically, such IR sensor systems use IR LEDs or a Vertical-Cavity, Surface-Emitting Lasers (VCSELs) as the source of infrared light. At the same time, such IR sources are typically integrated into the camera sensor unit, along with a built-in lens or diffusor for shaping the IR light flux into a specific field of illumination (FoI) tailored for the camera. This integration helps to minimise manufacturing costs and ensure that the FoI is optimised for the camera. However, by having the IR sensor and IR light source located in a single unit, it can be difficult to achieve the required IR illumination for certain applications. For example, it is desirable to use IR sensor systems for passenger seat occupancy detection. However, from an IR camera unit typically located in the driver's rear-view mirror module, the illuminator may struggle to deliver sufficient IR light to the rear passenger seats. Although the intensity of the IR light emitted may be increased to project the light further, this is undesirable because it may cause eye discomfort. Indeed, very high intensity IR light may risk damage to the driver's eyes due to the IR energy entering retina, and hence Original Equipment Manufacturers' will often look to decrease the overall level of IR illumination to protect a vehicle occupant's eyes.

At the same time as the above, it is commercially impractical to separate the IR camera and IR source into two separate units because of how these parts are specifically customised for use together in their specific usage application. That is, an IR illuminator for use in illuminating the rear seats of one vehicle having a particular IR camera would be unlikely to be usable in a different vehicle or with a different IR camera. This is because the emitter and lens configuration within the illuminator is selected for the field of view of a specific camera in a specific location. Accordingly, any change to the relative positions of the camera, the illuminator, or the cabin, would necessitate new components in a new assembly. The costs associated with this would be huge, and integration complexities would arise with each new application.

The above issues therefore limit the potential for further integration of IR sensing systems into the interior of vehicles. There is therefore a need for new improved solutions in IR sensor systems.

### Summary

According to a first aspect, there is provided an infrared illuminator including: an infrared, IR, emitter; and an IR window for transmitting IR radiation from the IR emitter to a field of illumination, wherein the IR window includes a electrochromic material for varying the transmittance of IR radiation through the IR window in response to an applied electric field.

In this way, the light flux emitted from the illuminator can be easily adjusted based on an applied electric field. This may thereby allow a standardised illumination unit to be manufactured as a common component and then be easily configured for use in a variety of different systems, applications, and vehicle configurations. This not only allows for reduced costs, but also provides for the field of illumination to be optimised depending on the specific requirements of the intended use case.

In embodiments, the electrochromic material is changeable between a transparent state and an opaque state in response to the application of the applied electric field.

In embodiments, the electrochromic material in the opaque state forms a diffuser pattern for reducing transmittance of IR radiation through the IR window. In this way, the IR light emitted by the illuminator may be dimmed, thereby allowing the intensity of IR radiation to be reduced for specific use cases.

In embodiments, the electrochromic material is polyelectrochromic for having a plurality of opaque states having different transmittances of IR radiation. In this way, the transparency of the IR window may be adjusted depending on the needs of the specific use case.

In embodiments, the IR window includes one or more controllable regions of electrochromic material within which the transmittance of IR radiation may be varied in response to the electric field applied to the respective region. In this way, the intensity of IR light may be adjusted in targeted regions of the field of illumination.

In embodiments, the one or more controllable regions includes a plurality of controllable regions.

In embodiments, the IR window includes a plurality of electric field conductors for independently applying an electric field to a subset of the plurality of controllable regions. In this way, the transmittance of IR light through one or more individual regions may be adjusted compared to the surrounding regions of the IR window. This may thereby allow adjustments within regions of the field of illumination based on the needs of the specific use case.

In embodiments, the subset of the plurality of controllable regions is an individual controllable region. In this way, the transmittance through each region may be adjusted independently.

In embodiments, the plurality of controllable regions are arranged in a grid array. In this way, the field of illumination may be flexibly adjusted depending on the needs of the specific use case.

In embodiments, the infrared illuminator further includes a housing for enclosing the IR emitter and includes an aperture, wherein the IR window is located in the aperture. In this way, the illuminator may be provided as an assembly with the housing supporting the IR emitter and IR window relative to one another.

In embodiments, the infrared illuminator further includes a controller for applying an electric field to the IR window for varying the transmittance of IR radiation therethrough.

In embodiments, reducing the transmittance of IR radiation through the IR window reduces the field of illumination. In this way, the size and/or shape of the field of illumination may be adjusted depending on the needs of the specific use case.

In embodiments, the IR emitter includes a VCSEL emitter having an emitter surface, wherein the emitter surface is parallel to the IR window. In this way, a compact, planar assembly may be provided.

In embodiments, the infrared illuminator is an automotive IR illuminator.

### Brief Description of Drawings

Illustrative embodiments will now be described with reference to the accompanying drawings in which:
Figure 1a shows a schematic illustration of an illuminator according to a first embodiment;
Figure 1b shows a plan view of the IR window through section A-A shown in Figure 1a;
Figure 2a shows a schematic illustration of an illuminator according to a second embodiment;
Figure 2b shows a plan view of the IR window through section A-A shown in Figure 2a;
Figure 3a shows a schematic illustration of an illuminator according to a third embodiment, and
Figure 3b shows a plan view of the IR window through section A-A shown in Figure 3a.

### Detailed Description

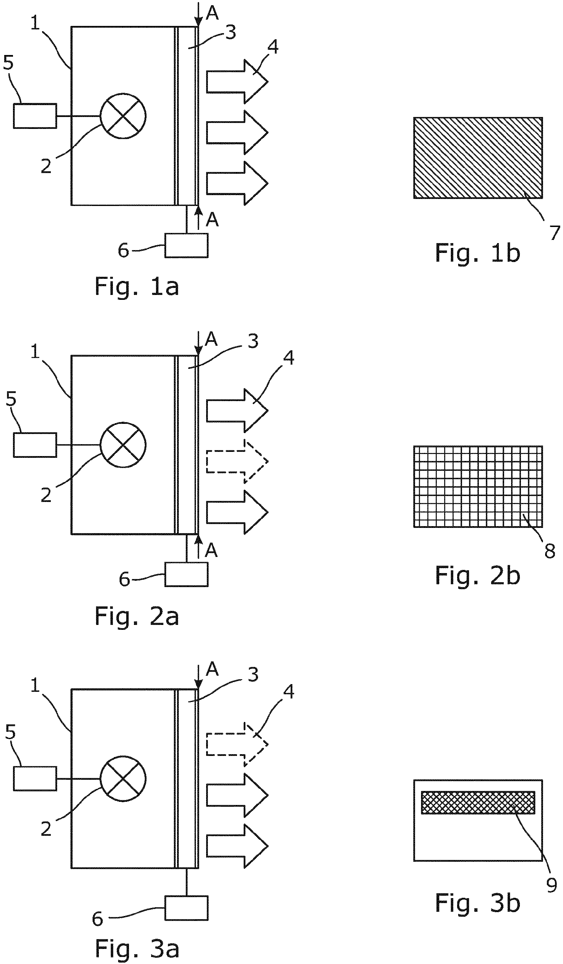

An illuminator 1 according to a first embodiment is shown in Figure 1a. The illuminator package houses an IR emitter 2, which is supplied by an external power source 5. In this embodiment, the IR emitter 2 is a VCSEL emitter. In other embodiments, the emitter 2 may be an IR LED. The IR emitter 2 is positioned for directing emitted IR light forward out of an aperture at the front of the illuminator 1.

The aperture at front of the illuminator 1 is provided with a controllable IR window 3 having electrochromic properties. The IR window 3 is an optical window for allowing IR light to be transmitted to the field of illumination 4, and in embodiments may form part of the illuminator's lens or diffuser assembly.

In this embodiment, the transparency of the whole IR window 3 may be varied under the control of controller 6 in order to vary the intensity of IR light transmitted therethrough. As such, the intensity of IR light output by the illuminator 1 onto the field of illumination 4 may be adjusted under the control of the controller 6.

In this connection, the IR window 3 includes an electrochromic material applied to a substrate, together with two electric field conductors. In use, the optical properties of the IR window 3 can be varied by the controller 6 applying a voltage to the electric field conductors for generating an electric field through the electrochromic material. This application of an electric field changes the state of the electrochromic material producing a visible diffusor pattern 7 in the window 3. This is shown in Figure 1b which shows a plan view of the IR window 3 through section A-A shown in Figure 1a. In this coloured or opaque state, the transmittance of IR light through the window 3 is reduced. Conversely, the controller 6 may apply a inversed electric field to remove the diffuser pattern 7 by transitioning the electrochromic material to a bleached or transparent state. In this state, IR light is emitted at its maximum intensity. Accordingly, by varying the state of the electrochromic material the field of illumination 4 may be variably dimmed depending on the requirements of the specific application.

Notably, the electrochromic colour change through the IR window 3 is persistent. Consequently, the controller 6 only needs to apply an electric field to adjust the transmittance for the required application. Once set, the IR window 3 therefore retains its dimming setting, without requiring ongoing active driving by the controller 6. That said, the controller may periodically update the dimming setting by reapplying the appropriate electric field.

In embodiments, the electrochromic material applied to the IR window 3 may be polyelectrochromic in that it may have a plurality of opaque states having different levels of transmittance. In such embodiments, the contrast of the diffuser pattern 7 may be varied depending on the magnitude of the electric field applied, and hence the transmittance of IR light can be more finely adjusted.

With the above arrangements, the overall intensity of IR light provided by the illuminator 1 may be adjusted for different applications. For example, in use cases in smaller vehicles, where the illuminator 1 may be located relatively close to a driver, the intensity of IR light may be reduced to mitigate risk of eye damage. Conversely, in larger vehicles, a higher transmissibility setting may be adopted for the IR window 3 to optimise for the enlarged cabin space. Nevertheless, advantageously, the same IR illuminator unit may be used in both cases, thereby providing for economies of scale.

A second embodiment is shown in Figures 2a and 2b. This embodiment operates in substantially the same way as the first embodiment, except that the controllable IR window 3 in this embodiment includes a plurality of independently controllable electrochromic cells 8. These cells 8 are shown in Figure 2b, with the transmittance of each cell being independently adjustable. The controller 6 includes a row-column driver for applying an electric field to individual cells 8 to adjust their transparency. As such, the transmittance of IR light through different regions of the IR window 3 may be adjusted by applying electric fields to cells 8 within those regions. Accordingly, the field of illumination and the intensity of illumination can be adjusted depending on the requirements of the specific application. For example, a smaller field of illumination may be provided for smaller vehicles by reducing the transmission of IR light through cells 8 around the periphery of the window 3. Equally, the intensity of IR light applied to the eye region of vehicle occupants may be reduced by dimming cells 8 at the top of the IR window 3 for mitigating the risks of eye damage. This thereby provides a flexible solution allowing a standard illuminator unit to be configured for a large variety of different applications.

A third embodiment is shown in Figures 3a and 3b. This embodiment operates in substantially the same way as the first and second embodiments, except that the IR window 3 in this embodiment includes an independently controllable zone 9, as shown in Figure 3b. The controller 6 includes a zonal driver for adjusting the transparency of the zone 9 within the window 3. As with the second embodiment, this thereby allows the field and intensity of illumination to be adjusted for different applications. In this example, the controllable zone 9 is provided at the top of the IR window for providing localised dimming in regions of the field of illumination 4 where a vehicle occupant's eyes are. As such, in smaller vehicles where the illuminator may be closer to an occupant, the intensity of IR light emitted may be reduced. Conversely, in other use applications, the IR window 3 may be left transparent to provide a consistent field of illumination. It will be understood that other embodiments may include two or more controllable zones for allowing configuration to a greater variety of use applications. Accordingly, a configurable illuminator 1 may be provided which allows for the selective restriction of IR light in certain regions in a similar way to the second embodiment, but without requiring the more complex cell-by-cell driving associated with a cellular IR window 3. Therefore, a lower cost implementation may be provided requiring fewer electrical signals and electric field conductor connecting lines.

With the above arrangements, the light flux emitted from the illuminator can be easily adjusted, thereby allowing a standardised illumination unit to be used for different systems, applications, and vehicle configurations. That is, the illuminators may be manufactured as a standard off-the-shelf component, and then simply adjusted using a controller depending on the specific application requirements. This thereby allows for the cost advantages of economies of scale.

In turn, the above also provides for a more targeted use of IR illuminators within the vehicle. For example, in the case of illuminating the rear passenger seats, rather than simply increasing the intensity of IR light emitted from a unit located in the front of the vehicle, a separate illuminator may be provided in the rear. This approach thereby avoids very high intensity IR light being emitted directly in front of the driver's eyes, and hence mitigates the potential risk of eye damage. At the same time, the IR light energy delivered to the area of rear seats is increased, allowing for improved sensor functionality.

Moreover, the ability to selectively adjust the intensity of IR light in different regions of the field of illumination also allows for target specific optimisations. For example, as described in relation to the third embodiment, the intensity of IR light delivered to higher regions of the interior cabin, where a vehicle occupant's eyes are likely to be, may be reduced. At the same time, a greater intensity of IR light may be applied to lower regions of the interior cabin to enhance sensor detection in these regions. This customised illumination pattern may therefore improve the performance of, for instance, passengers seat analysis, while decreasing the overall illumination level to protect the vehicle occupants' eyes.

It will be understood that the embodiments illustrated above shows an application only for the purposes of illustration. In practice, embodiments may be applied to many different configurations, the detailed embodiments being straightforward for those skilled in the art to implement.

For example, it will be understood that although in the above embodiments the controller is described as being separate to the illuminator, in other embodiments it may be integrated into the illuminator package. Equally, although the illuminator has been described as a separate unit to the IR camera, it will be understood that a combined assembly may be provided with both the illuminator and camera integrated into one unit.

## Claims

1. An infrared illuminator comprising:
an infrared, IR, emitter; and
an IR window for transmitting IR radiation from the IR emitter to a field of illumination,
wherein the IR window comprises a electrochromic material for varying the transmittance of IR radiation through the IR window in response to an applied electric field.

2. An infrared illuminator according to claim 1, wherein the electrochromic material is changeable between a transparent state and an opaque state in response to the application of the applied electric field.

3. An infrared illuminator according to claim 2, wherein the electrochromic material in the opaque state forms a diffuser pattern for reducing transmittance of IR radiation through the IR window.

4. An infrared illuminator according to claim 2 or 3, wherein the electrochromic material is polyelectrochromic for having a plurality of opaque states having different transmittances of IR radiation.

5. An infrared illuminator according to any preceding claim, wherein in the IR window comprises one or more controllable regions of electrochromic material within which the transmittance of IR radiation may be varied in response to the electric field applied to the respective region.

6. An infrared illuminator according to claim 5, wherein the one or more controllable regions comprise a plurality of controllable regions.

7. An infrared illuminator according to claim 6, wherein the IR window comprises a plurality of electric field conductors for independently applying an electric field to a subset of the plurality of controllable regions.

8. An infrared illuminator according to claim 7, wherein the subset of the plurality of controllable regions is an individual controllable region.

9. An infrared illuminator according to any of claims 6 to 8, wherein the plurality of controllable regions are arranged in a grid array.

10. An infrared illuminator according to any preceding claim, further comprising:
a housing for enclosing the IR emitter and comprising an aperture, wherein the IR window is located in the aperture.

11. An infrared illuminator according to any preceding claim, further comprising:
a controller for applying an electric field to the IR window for varying the transmittance of IR radiation therethrough.

12. An infrared illuminator according to any preceding claim, wherein reducing the transmittance of IR radiation through the IR window reduces the field of illumination.

13. An infrared illuminator according to any preceding claim, wherein the IR emitter comprises a VCSEL emitter having an emitter surface, wherein the emitter surface is parallel to the IR window.

14. An infrared illuminator according to any preceding claim, wherein the infrared illuminator is an automotive IR illuminator.
